# EUROPÄISCHE PATENTSCHRIFT

(11) **EP 2 551 239 B1**
(45) Veröffentlichungstag und Bekanntmachung des Hinweises auf die Patenterteilung: **26.03.2014**
(21) Anmeldenummer: 12173743.1
(22) Anmeldetag: 27.06.2012
(51) Int. Cl.: C01B 33/107, C01B 33/035

(54) **Verfahren zur Produktion von Polysilicium**
Process for producing polysilicon
Procédé de production de polysilicium

(30) Priorität: 05.07.2011 DE 102011078676
(43) Veröffentlichungstag der Anmeldung: 30.01.2013
(73) Patentinhaber: Wacker Chemie AG, 81737 München (DE)
(72) Erfinder: Häckl, Dr. Walter, 84367 Zeilarn (DE); Müller, Dr. Barbara, 84567 Erlbach (DE); Ring, Robert, 84533 Haiming (DE)
(74) Vertreter: Killinger, Andreas

(56) Entgegenhaltungen:
- EP-A1- 2 298 701
- EP-A2- 0 133 209
- EP-A2- 0 305 867
- EP-A2- 1 992 593
- DE-A1-102007 047 210

## Beschreibung

Die Erfindung betrifft ein Verfahren zur Produktion von Polysilicium.

Polykristallines Silicium (kurz: Polysilicium) dient als Ausgangsmaterial bei der Herstellung von einkristallinem Silicium mittels Tiegelziehen (Czochralski- oder CZ-Verfahren)- oder mittels Zonenschmelzen (Floatzone oder FZ-Verfahren). Dieses einkristalline Silicium wird in Scheiben (Wafer) zertrennt und nach einer Vielzahl von mechanischen, chemischen und chemomechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein-oder multikristalline Silicium zur Fertigung von Solarzellen für die Photovoltaik dient.

Das polykristalline Silicium wird üblicherweise mittels des Siemens-Prozesses hergestellt. Dabei werden in einem glockenförmigen Reaktor ("Siemens-Reaktor") dünne Filamentstäbe ("Dünnstäbe") aus Silicium durch direkten Stromdurchgang erhitzt und ein Reaktionsgas enthaltend eine Silicium enthaltende Komponente und Wasserstoff eingeleitet.

Auch kann das polykristalline Silicium in Form von Granulat mit speziellen Wirbelschichtreaktoren (FBR) hergestellt werden, wobei ein Reaktionsgas enthaltend eine Silicium enthaltende Komponente von unten über Düsen in einen Reaktionsraum eingebracht wird, so dass eine Wirbelschicht des bereits vorhandenen Granulats entsteht und die Silicium enthaltende Komponente an der Oberfläche des Granulats zu Silicium reagiert.

Die Silicium enthaltende Komponente des Reaktionsgases ist in der Regel Monosilan oder ein Halogensilan der allgemeinen Zusammensetzung SiHₙX₄₋ₙ (n=O, 1, 2, 3; X = CI, Br, I). Bevorzugt handelt es sich um ein Chlorsilan oder Chlorsilangemisch, besonders bevorzugt um Trichlorsilan.

Überwiegend wird SiH₄ oder SiHCI₃ (Trichlorsilan, TCS) im Gemisch mit Wasserstoff eingesetzt.

Trichlorsilan wird vorzugsweise über die Umsetzung von metallurgischem Silicium (MGS- metallurgical grade silicon) mit HCl und in anschließender Reinigung in einer Destillation erzeugt. Sowohl in Siemens-Reaktoren als auch in FBRs entsteht während der Abscheidung Abgas, das immer noch eine beträchtliche Menge an Silicium beinhaltendes Gas enthält. Die Zusammensetzung des Gases ändert sich entsprechend des verwendeten Prozesses. Der Aufbereitung dieses Abgases gilt aus Kostengründen vermehrte Aufmerksamkeit seitens der Industrie.

Dem Stand der Technik sind Methoden bekannt, wie das Abgas der Siliciumabscheidung prinzipiell aufbereitet werden kann.

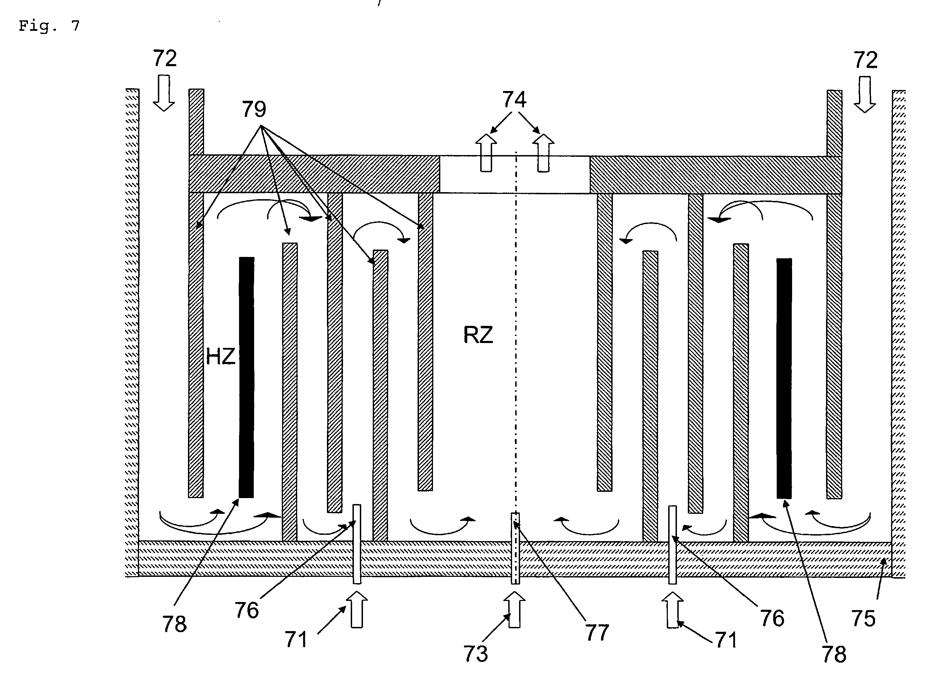

Entsprechende Kreisprozesse sind in den Figuren 7 und 8 in O'-Mara, B. Herring, L. Hunt, Handbook of Semiconductor Silicon Technology, ISBN 0-8155-1237-6 auf Seite 58 dargestellt.

Das Abgas aus dem Abscheidereaktor (Siemens oder FBR) wird dabei einer zweifachen Kondensationsvorrichtung zugeführt, deren Kondensat über eine Destillationskolonne in niedersiedende und hochsiedende Anteile getrennt wird, wobei die niedersiedenden Anteile wieder der Abscheidung zugeführt werden.

Die hochsiedenden Anteile beinhalten zu einem großen Teil Siliciumtetrachlorid (STC), das in einer Konvertierungsvorrichtung (Konverter) zu TCS umgewandelt werden kann.

Die nach der Kondensation übrig bleibenden gasförmigen Anteile des Abgases werden einer Adsorption zugeführt. Hier wird Wasserstoff von den anderen Bestandteilen des Gasstromes abgetrennt und wieder dem Abscheideprozess zugeführt. Die übrig bleibenden Komponenten werden in einer weiteren Kondensation in flüssige und gasförmige Komponenten getrennt.

Die nach der Kondensation flüssigen Komponenten werden der Destillation zugeführt und nach Trennung in der Abscheidung wieder verwendet. Die gasförmigen Anteile (in den Figuren 7 und 8 in O'Mara mit "HCl" gekennzeichnet) können entweder als Chlorwasserstoff (HCl) verkauft (vgl. Fig. 7 in O'Mara) oder in der Roherzeugung wiederverwertet (vgl. Fig. 8 in O'Mara) werden.

Der Nachteil der in O'Mara gezeigten Verfahren ist, dass sich nicht gewünschte Stoffe wie zum Beispiel Bor und Phosphor in der Abscheidung anreichern und so die Qualität des abgeschiedenen Siliciums negativ beeinflussen.

Die zuvor bereits erwähnte "Adsorption" wird dazu verwendet, Wasserstoff von noch enthaltenen Chlorsilanen und gegebenenfalls auch von HCl zu reinigen.

Dabei wird mit Chlorsilanen und gegebenenfalls auch mit Chlorwasserstoff verunreinigter Wasserstoff bei hohem Druck (Druck zwischen 5 und 20 bar, bevorzugt zwischen 9 und 16 bar) und niedriger Temperatur (typische Größenordnung T₁= 20°C) durch ein Bett von Aktivkohle geleitet. Statt Aktivkohle können auch Molekularsiebe, wie in DE 1 106 298 B beschrieben, verwendet werden. Neben Aktivkohle können aber auch Siliciumoxid und Aluminosilikate als Adsorber zum Einsatz kommen, vgl. CN 101279178A*.*

Die Verunreinigungen werden in der Aktivkohle physikalisch und/oder chemisch adsorbiert.

Die Aktivkohle wird nach der Beladung durch diese nicht gewünschten Stoffe mittels eines Regenerationsschrittes "entladen". Dabei wird der Druck erniedrigt (typische Größenordnung P₂= 1 bar) und die Temperatur erhöht (typische Größenordnung T₂ = 200 °C).

Bei der hohen Temperatur und dem niedrigen Druck werden die Gasbestandteile, die vorher adsorbiert wurden, desorbiert, also in ein Spülgas abgegeben.

Üblicherweise wird das Spülgas (Wasserstoff) danach zusammen mit den Verunreinigungen gekühlt, um die bei tiefen Temperaturen flüssigen von den gasförmigen Komponenten zu trennen. Dies ist beispielsweise aus DE 29 18 060 A1 bekannt.

Danach wird der Adsorber wieder gekühlt und steht wieder zur Adsorption zur Verfügung.

Die gasförmigen Komponenten, die im Stand der Technik überwiegend HCl beinhalten, werden der Roherzeugung zugeführt (vgl. Fig. 7 und 8 in O'Mara).

Die flüssigen Komponenten werden im Stand der Technik einer Destillation zugeführt, wobei niedersiedende und höhersiedende Komponenten getrennt werden. Die nieder siedenden Komponenten werden der Abscheidung zugeführt und die höher siedenden Komponenten der Konvertierung.

Üblicherweise verwendet man mehrere Adsorber, die sich in einer jeweils anderen Phase befinden, um eine kontinuierliche Adsorptionsleistung zu gewährleisten.

Die Anzahl der zu verwendenden Adsorber wird durch die Verweildauer in den entsprechenden Phasen "Adsorption", "Heizen", "Desorption" und "Kühlen" bestimmt.

Je länger die Phase "Adsorption" im Vergleich zu den übrigen Phasen ist, desto weniger Adsorber müssen parallel betrieben werden.

Um die Investitionskosten für die Adsorber zu reduzieren, wird meist versucht, die Zeiten der Phasen "Heizen", "Desorption" und "Kühlen" möglichst klein zu halten.

Die im Stand der Technik gezeigte komplette Rückführung der nieder siedenden Komponenten aus der Desorption in den Abscheideprozess führt dazu, dass Verunreinigungen wie vor allem Bor und Phosphor (aber auch Al, As, C) sich im Abscheidekreislauf sammeln/anreichern und so zu höheren Konzentrationen im produzierten Silicium führen.

Zwar werden alle Chlorsilane für den Abscheideprozess erhalten, jedoch sinkt die Qualität des abgeschiedenen Siliciums.

Aufgabe der Erfindung war es daher, ein Verfahren bereit zu stellen, bei dem alle Chlorsilane optimal im Stoffkreislauf genutzt werden können.

Die Aufgabe wird gelöst durch ein Verfahren zur Produktion von Polysilicium, umfassend
a) Abscheidung von polykristallinem Silicium auf Filamenten in einem Abscheidereaktor mittels eines Reaktionsgases enthaltend eine Silicium enthaltende Komponente, die Trichlorsilan umfasst, und Wasserstoff, wobei die molare Sättigung der Silicium enthaltenden Komponente bezüglich des Wasserstoffs mindestens 25% beträgt;
b) Zuführen eines Abgases aus der Abscheidung in eine Vorrichtung zum Kühlen des Abgases,
   i) wobei durch die Kühlung kondensierende Komponenten des Abgases enthaltend STC zu einer Vorrichtung geführt werden, die eine destillative Reinigung des Kondensats ermöglicht, und
   ii) bei der Kühlung nicht kondensierende Komponenten zu einer Adsorptions- bzw. Desorptionseinheit geführt werden;
c) wobei ein durch Adsorption gereinigter erster Stoffstrom jener nicht kondensierenden Komponenten erhalten wird, der Wasserstoff enthält; und
d) wobei während einer Regeneration der Adsorptionseinheit mittels Desorption und Spülen mit Spülgas ein zweiter Stoffstrom jener nicht kondensierenden Komponenten erhalten wird, der STC enthält, und einem Konverter zur Konvertierung von STC in TCS zugeführt wird.

Die erfindungsgemäßen Verfahren wird im Folgenden auch anhand von **Fig.** 1-7 erläutert.
**Fig. 1** zeigt einen bevorzugten Kreisprozess im Rahmen der Erfindung.
**Fig. 2** zeigt die Konvertierung mit Gas aus der Desorption, wobei das Gas zwischen Reaktor und Kühlstrecke zugeführt wird.
**Fig. 3** zeigt den Verlauf der HCl-Konzentration im Abgas des Abscheidereaktors in Abhängigkeit von der molaren Chlorsilan-Sättigung.
**Fig. 4** zeigt einen weiteren bevorzugten Kreisprozess im Rahmen der Erfindung.
**Fig. 5** zeigt die Konvertierung mit Gas aus der Desorption, wobei das Gas direkt dem Reaktor zugeführt wird.
**Fig. 6** zeigt den schematischen Aufbau eines Konverters, wie er im Rahmen der Erfindung, insb. bei direkter Zuführung des desorbierten Gases in den Konverter, benutzt werden kann.
**Fig. 7** zeigt den schematischen Aufbau eines Konverters mit Heiz- und Umlenkelementen, wie er im Rahmen der Erfindung, insb. bei direkter Zuführung des desorbierten Gases in den Konverter, benutzt werden kann.

### Liste der verwendeten Bezugszeichen

- **11**: Abscheidung
- **12**: Kühlstrecke
- **13**: Adsorption/Desorption
- **14**: Destillation
- **15**: Konvertierung
- **16**: Kondensatsammler
- **17**: Stoffstrom beinhaltend frischen Wasserstoff
- **18**: Abgasstrom aus der Abscheidung beinhaltend STC und TCS
- **19**: Stoffstrom der nach der Kühlstrecke **12** verbleibenden gasförmigen Anteile
- **110**: Stoffstrom beinhaltend aufbereiteten Wasserstoff
- **111**: Stoffstrom beinhaltend Wasserstoff als Spülgas zur Desorption
- **112**: Stoffstrom der bei der Kühlung entstehendes Kondensat
- **113**: durch die Desorption gewonnener Stoffstrom
- **114**: Stoffstrom beinhaltend Wasserstoff zur Konvertierung **15**
- **115**: Stoffstrom beinhaltend HCl
- **116**: Stoffstrom beinhaltend STC
- **117**: Stoffstrom beinhaltend STC und TCS
- **118**: zur Wiederverwertung in der Abscheidung **11** vorgesehener Stoffstrom enthaltend TCS
- **119**: frisches TCS enthaltender Stoffstrom
- **21**: Stoffstrom beinhaltend Wasserstoff
- **22**: Stoffstrom beinhaltend STC
- **23**: Vorrichtung zur Konvertierung
- **24**: Stoffstrom beinhaltend DCS
- **25**: Kühlstrecke
- **26**: Stoffstrom des Kondensats aus der Kühlstrecke **25**
- **27**: Stoffstrom beinhaltend HCl
- **41**: Abscheidung
- **42**: Kühlstrecke
- **43**: Adsorption/Desorption
- **44**: Destillation
- **45**: Konvertierung
- **46**: Kondensatsammler
- **47**: Stoffstrom beinhaltend frischen Wasserstoff
- **48**: Abgasstrom aus der Abscheidung beinhaltend STC und TCS
- **49**: Stoffstrom der nach der Kühlstrecke **42** verbleibenden gasförmigen Anteile
- **410**: Stoffstrom beinhaltend aufbereiteten Wasserstoff
- **411**: Stoffstrom beinhaltend Wasserstoff als Spülgas zur Desorption, wahlweise aus dem Stoffstrom **410** entnommen
- **412**: Stoffstrom der bei der Kühlung entstehendes Kondensat
- **413**: durch die Desorption gewonnener Stoffstrom
- **414**: Stoffstrom beinhaltend Wasserstoff zur Konvertierung **15**
- **415**: Stoffstrom beinhaltend HCl
- **416**: Stoffstrom beinhaltend STC
- **417**: Stoffstrom beinhaltend STC und TCS
- **418**: zur Wiederverwertung in der Abscheidung **41** vorgesehener Stoffstrom enthaltend TCS
- **419**: frisches TCS enthaltender Stoffstrom
- **420**: Dreiwegeventil
- **421**: Stoffstrom zur Eingangsseite der Kühlstrecke
- **422**: Stoffstrom zur Konvertierung
- **51**: Stoffstrom beinhaltend Wasserstoff
- **52**: Stoffstrom beinhaltend STC
- **53**: Vorrichtung zur Konvertierung
- **54**: Stoffstrom beinhaltend DCS
- **55**: Kühlstrecke
- **56**: Stoffstrom des Kondensats aus der Kühlstrecke **55**
- **57**: Stoffstrom beinhaltend HCl
- **61**: Eduktgasstrom beinhaltend Wasserstoff
- **62**: Eduktgasstrom beinhaltend Siliciumtetrachlorid (STC)
- **63**: desorbierte Gasstrom als dritter Eduktstrom in die Reaktionszone
- **64**: Abgasstrom des Konverters zur Kühlstrecke
- **65**: Druck tragenden Hülle des Reaktors
- **66**: Drossel
- **67**: eine oder mehrere Düsen
- **WT1**: Wärmetauscher 1
- **WT2**: Wärmetauscher 2
- **HZ**: Heizzone des Konverters
- **RZ**: Reaktionszone des Konverters
- **71**: Eduktstrom beinhaltend Wasserstoff
- **72**: Eduktstrom beinhaltend Siliciumtetrachlorid
- **73**: Desorbierter Gasstrom
- **74**: Produktstrom beinhaltend Trichlorsilan und HCl
- **75**: innere Wand des druckbeständigen Gehäuses, beinhaltend den unteren Boden und die Mantelfläche
- **76**: Düsenkreis für Eduktstrom Wasserstoff
- **77**: Düse für desorbierten Gasstrom
- **78**: Heizelement
- **79**: zylindrische Gasumlenkelemente

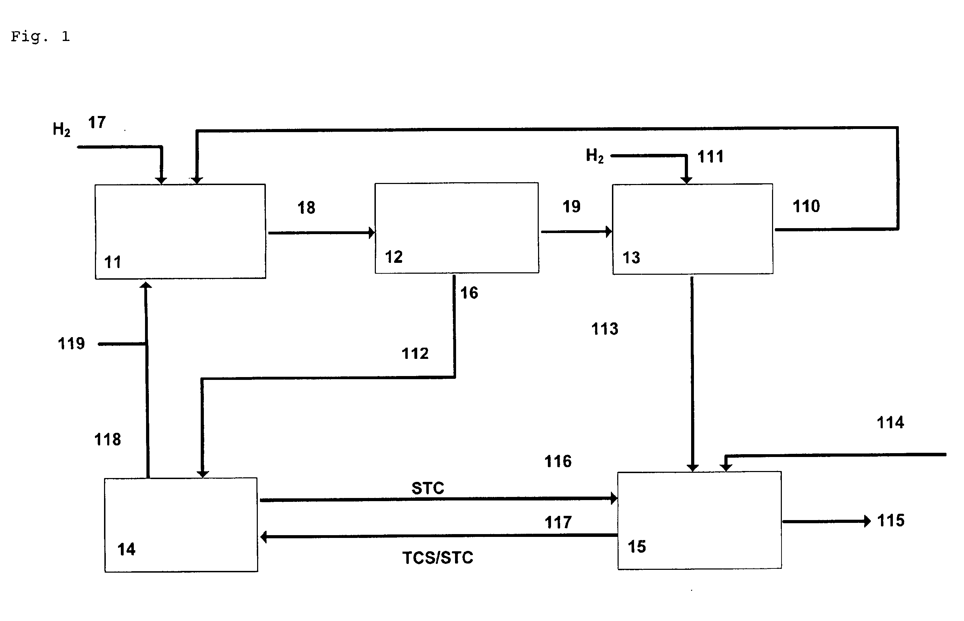

**Fig. 1** zeigt, dass der während der Regeneration des Adsorbers **13** durch Desorption gewonnene Stoffstrom **113** komplett zur Konvertierung **15** geleitet wird.

Zur Abscheidung **11** wird ein Silicium enthaltende Komponente (z.B. TCS oder DCS) benötigt, die zum einen frisches TCS **119** und zum anderen wiederverwertetes TCS **118** enthält.

Der für die Abscheidung benötigte Wasserstoff beinhaltet aufbereiteten Wasserstoff **110** und zum Ausgleich der Wasserstoffverluste auch frischen Wasserstoff **17.**

Der Abgasstrom aus der Abscheidung **18** wird in einer Kühlstrecke **12** gekühlt, vorzugsweise auf eine Temperatur von kleiner oder gleich -60°C gekühlt, ganz besonders bevorzugt auf eine Temperatur kleiner dem Taupunkt der HCl bei entsprechendem HCl-Gehalt im Abgas und entsprechendem Druck gekühlt wird.

Die Kühlstrecke **12** beinhaltet dabei vorzugsweise diverse Vorrichtungen zum Kühlen von gasförmigen Stoffen beispielsweise Luftkühler, mit kaltem Wasser betriebene Kühler, Solekühler oder Kühler mit anderen Kühlmedien (Ammoniak, halogenierte Kohlenwasserstoffe oder verflüssigte Gase).

Das in der Kühlstrecke **12** entstehende Kondensat **112** wird in einen oder mehreren Kondensatsammlern **16** aufgefangen und zur Destillation **14** geleitet. Aufgabe der Destillation **14** ist es, TCS und STC zu trennen und TCS der Abscheidung **118** und STC der Konvertierung **116** zuzuführen.

In der Kühlstrecke nicht kondensierende Gaskomponenten **19** werden zu einer Adsorptionsvorrichtung **13** geleitet.

Dort werden intermittierend mehrere Adsorber betrieben, die bei der Desorption mit einem Spülgas **111,** vorzugsweise Frischwasserstoff, gespült werden.

Der so entstehende Stoffstrom **113** wird zur Konvertierung **15** geleitet.

Der in der Adsorption gereinigte Stoffstrom **110,** der hauptsächlich Wasserstoff beinhaltet, wird zurück zur Abscheidung **11** geleitet.

Der Stoffstrom zwischen Abscheidung, Kühlstrecke, Adsorber und schließlich wieder Abscheidung wird im Folgenden als "Abscheidekreis" bezeichnet.

Die Hochtemperatur-Konvertierung **15** verwandelt STC **116** zu TCS **117** unter Verbrauch von Wasserstoff **114.** Auf den bevorzugten Aufbau des Konverters wird später noch eingegangen.

Der Stoffstrom des Produktes der Konvertierung **117** beinhaltet neben dem gewünschten TCS je nach Selektivität des Prozesses nicht unerhebliche Mengen an STC.

Zusätzlich fällt bei der Konvertierung ein Stoffstrom an HCl **115** an, der beispielsweise zur Roherzeugung von TCS durch Chlorierung von metallurgischem Silicium verwendet werden kann.

Die Konvertierung beinhaltet vorzugsweise zwei Bestandteile, nämlich einen Konvertierreaktor und eine eigene Kühlstrecke.

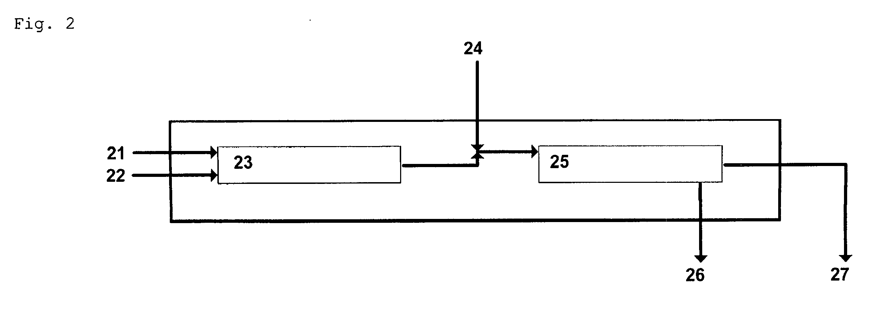

**Fig. 2** zeigt den Aufbau einer bevorzugt verwendeten Konvertierung.

Der Stoffstrom beinhaltend Wasserstoff **21** und HCl **22** wird in eine Vorrichtung zur Konvertierung **23** geführt. Der Abgasstrom der Konvertierung wird vermischt mit dem Stoffstrom der Desorption **24** in einer Kühlstrecke 25 eingebracht. Nach der Kühlstrecke erhält man zwei Stoffströme: Das Kondensat aus der Kühlstrecke **26** und einen gasförmigen Anteil beinhaltend HCl **27.**

In diesem Fall ist besonders vorteilhaft, dass der Stoffstrom **24** gasförmig zur Konvertierung gebracht wird.

Erfindungswesentlich ist es, dass die molare Sättigung der Silicium enthaltenden Komponente des Reaktionsgases, also z.B. die Trichlorsilan-Sättigung, bei der Abscheidung größer ist als 25%, vorzugsweise größer als 27%, besonders bevorzugt größer 29% und ganz besonders bevorzugt größer als 31%, jeweils bezüglich des Wasserstoffs im Reaktionsgas.

Gleichzeitig wird eine Erhöhung der Konzentration von nicht gewünschten Stoffen wie etwa Bor oder Phosphor im Abscheidekreislauf vermieden, da sie offenbar über die Desorption zur Konvertierung transportiert werden.

Die HCl-Konzentration im Stoffstrom aus der Desorption **24** kann überraschenderweise eingestellt werden über die verwendete Sättigung der Silicium enthaltenden Komponente des Reaktionsgases, also beispielsweise des Chlorsilanstroms, beim Abscheideprozess.

Eine zu kleine Sättigung führt offenbar zu einer hohen HCl-Konzentration.

Eine niedrigere Sättigung in der Abscheidung führt offenbar zu einer zu hohen HCl-Konzentration in der Kühlstrecke der Konvertierung und die wiederum bedingt zwangsweise eine größere Auslegung der Kühlstrecke und damit eine höhere Investitionssumme.

Ein Vorteil dieser Methode besteht darin, dass alle Silicium enthaltenden Komponenten weitestgehend wiederverwertet werden können.

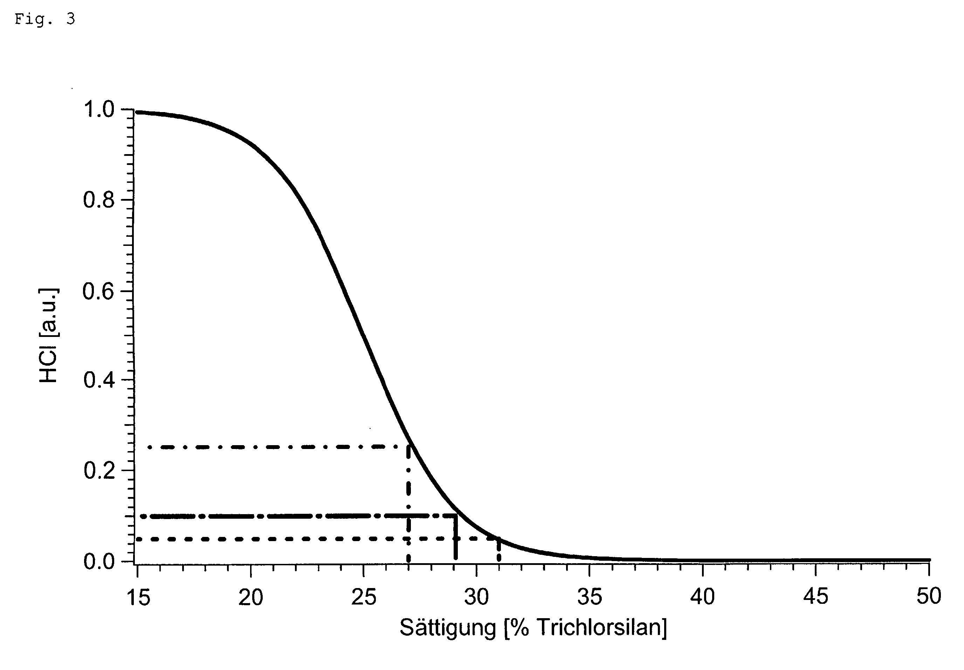

Details aus einem Versuch mit steigender Trichlorsilan-Sättigung und gemessener HCl-Konzentration sind in **Fig. 3** zu sehen.

Die HCl-Konzentration nimmt ab einer Sättigung von 15% mit steigender Sättigung ab. Dieser Punkt wird als Referenzpunkt angenommen. Bei kleineren Sättigungen bleibt zunächst die HCl-Konzentration nahezu konstant. Bei einer Sättigung von 25% oder größer ist beispielsweise die HCl-Konzentration auf die Hälfte oder weniger bezogen auf den Referenzpunkt gesunken.

Wird eine Sättigung von 27% oder mehr eingestellt, reduziert sich die HCl-Konzentration auf ein Viertel oder weniger bezogen auf den Referenzpunkt.

Ab einer Sättigung von 29% stellt sich eine HCl-Konzentration kleiner als 10 % des Referenzpunktes ein.

Und ab einer Sättigung von 31 % bleibt die HCl-Konzentration unter 5 % bezogen auf den Referenzpunkt.

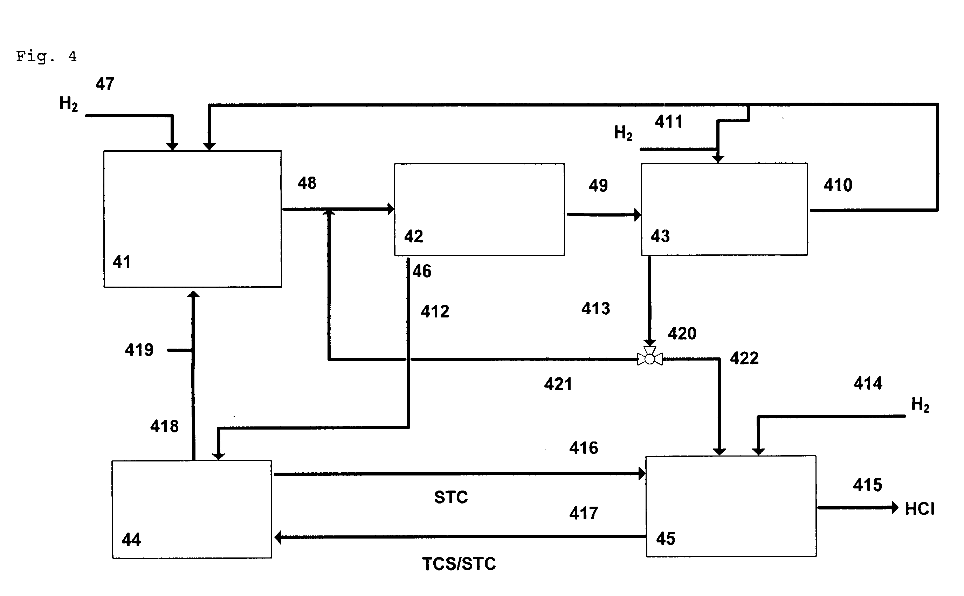

**Fig. 4** zeigt einen weiteren bevorzugten Kreisprozess, bei dem während der Regeneration des Adsorbers **43** der durch Desorption gewonnene Stoffstrom **413** mittels eines Gaschromatographen online auf den Anteil von Dichlorsilan (DCS) im Stoffstrom Überprüft wird.

Ist der molare prozentuale Anteil von DCS kleiner als der Anteil aus der Summe aus TCS und STC wird der Stoffstrom über ein Dreiwegeventil **420** zur Eingangsseite der Kühlstrecke **422** geleitet.

Ist der Anteil größer, wird der Stoffstrom **422** komplett zur Konvertierung **45** geleitet.

Gegenüber dem in **Fig. 1** dargestellten Kreisprozess wurden folgende Modifikationen vorgenommen.

Zwischen der Adsorbervorrichtung **43** und der Konvertierung **45** wird der Gasstrom gasförmig über ein Dreiwegeventil **420** geleitet, das den Gasstrom entweder zum Eingang der Kühlstrecke **421** oder zur Konvertierung **422** leiten kann.

Die Temperatur wird während der Desorption mit einer Rate von kleiner als 0.9 K/min erhöht.

Die Anfangstemperatur beträgt etwa 20°C, die Endtemperatur etwa 160°C.

Eine kleine Temperaturerhöhungsrate bedeutet zunächst einen wirtschaftlichen Nachteil.

Allerdings wird mit einer kleinen Temperaturerhöhungsrate überraschenderweise eine grobe Trennung zwischen DCS, TCS und STC während der Desorption erreicht.

Dazu wird der desorbierte Gasstrom aus den Adsorbern **43** mit Hilfe einer Messeinrichtung auf den Gehalt von DCS, TCS und STC geprüft.

Die Messeinrichtung enthält dabei besonders bevorzugt ein Prozess-Gaschromatographen.

Wird der relative Anteil des DCS im Gasstrom größer als die Summe der Gasanteile STC und TCS, wird das Dreiwegeventil so eingestellt, dass der Gasstrom zur Konvertierung geleitet wird.

Sonst wird der Gasstrom zum Eingang der Kühlstrecke geleitet.

Eine weitere Modifikation betrifft die Versorgung der Adsorber mit Spülgas, idealer weise Wasserstoff, zum Spülen.

Es hat sich als vorteilhaft erwiesen, dass zumindest zusätzlich Wasserstoff direkt aus dem Abscheidekreislauf **411** als Spülgas verwendet wird.

Hier findet offenbar eine zusätzliche Ausschleusung von möglichen Verunreinigungen statt.

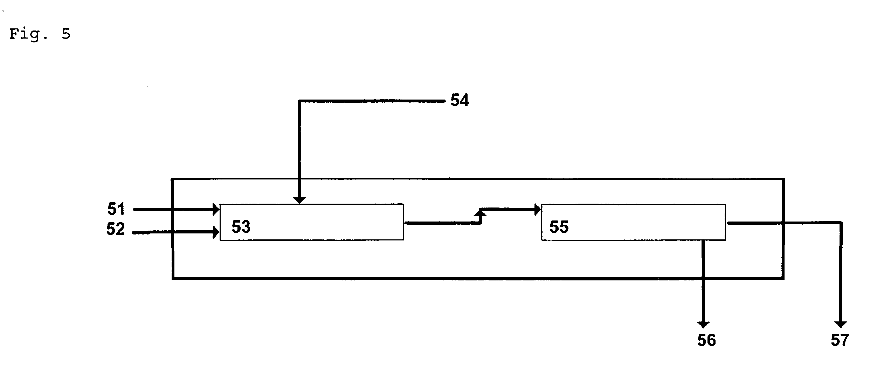

**Fig. 5** zeigt eine weitere bevorzugte Ausführungsform, die vorsieht, dass der während der Regeneration des Adsorbers durch Desorption gewonnene Stoffstrom **54** direkt in den Konvertierungsreaktor **53** eingebracht wird (und nicht zwischen Reaktor und Kühlstrecke wie in **Fig. 2****).** Wie in **Fig. 2** wird der Konvertierreaktor **53** mit einem vorwiegend H₂ enthaltenden Stoffstrom **51** und einem vorwiegend STC enthaltendem Stoffstrom **52** versorgt. Der dabei entstehende Produktstrom wird in einer Kühlstrecke 55 in einen Kondensatstrom **56** und in einen vorwiegend HCl enthaltenden Stoffstrom **57** getrennt.

Dabei wird das aus der Desorption stammende Gasgemisch 54 (vorwiegend beinhaltend DCS), gasförmig direkt in die Reaktionszone des Konvertierreaktors eingebracht.

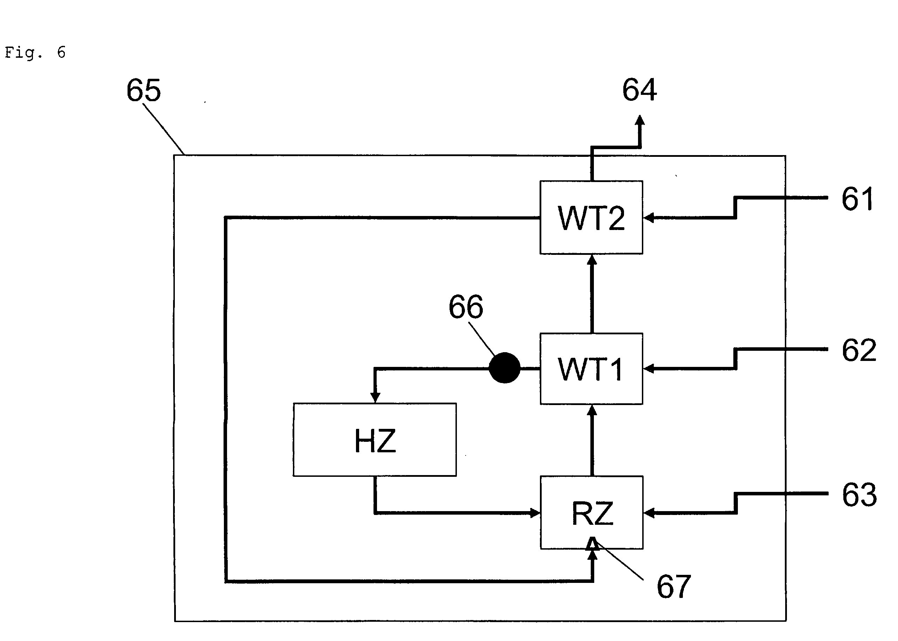

Besonders bevorzugt wird dabei ein Reaktor verwendet, wie er in **Fig. 6** gezeigt wird.

Im "heißeren" Wärmetauscher **WT1,** der unmittelbar an die Reaktionszone **RZ** anschließt, wird der Eduktgasstrom **62** beinhaltend Siliciumtetrachlorid durch das Abgas der Reaktionszone **(RZ)** aufgeheizt.

Wärmetauscher **WT1** besteht aus Graphit, aus Siliciumcarbid oder aus mit Siliciumcarbid beschichtetem Graphit.

Eine optionale, aber besonders bevorzugte Drossel **66,** die zum Beispiel aus einer Verengung einer Rohrleitung, des Einbaues einer geeigneten Armatur oder der geringere Auslegung des Durchmessers der verwendeten Rohrleitungen bestehen kann, sorgt für eine definierte Druckdifferenz zwischen dem Ausgang des Wärmetauschers **WT1** und der Heizzone **HZ.**

In der Heizzone wird der Eduktgasstrom **62** entlang Heizelementen geführt, so dass die Temperatur erhöht wird. Die Heizelemente können dabei bevorzugt so aufgebaut sein wie in DE 10 2005 046 703 A1 beschrieben.

Die erreichte Temperatur muss dabei höher sein, als die für die Reaktion benötigte.

Dieser so aufgeheizte und druckreduzierte Eduktgasstrom **62** wird in die Reaktionszone **RZ** des Reaktors eingebracht.

Der Eduktgasstrom **61** wird mittels der "kälteren" Wärmetauschereinheit **WT2** aufgeheizt, die bevorzugt aus Stahl oder Edelstahl besteht, an der Wärmetauschereinheit **WT1** anschließt und dem schon etwas kälteren Produktgas ausgesetzt ist.

Der Eduktgasstrom **61** wird nach dem Erwärmen in Wärmetauschereinheit **WT2** über eine oder mehrere Düsen **67** in die Reaktionszone gebracht.

Die Temperatur des Eduktgasstromes **61** nach Erwärmung in Wärmetauschereinheit **WT2** ist dabei geringer als die für die Reaktion benötigte Temperatur.

Der Eduktgasstrom **61** beinhaltet den Wasserstoff, der für die Reaktion in **RZ** notwendig ist.

Da der Produktstrom in der Wärmetauschereinheit **WT1** bereits ausreichend abgekühlt wurde, ist der Einsatz von Stahl für die Wärmetauschereinheit **WT2** prozesstechnisch unbedenklich.

Aus Gründen der Raum-Zeit-Ausbeute wird der Konvertierungsreaktor im Überdruckbereich betrieben.

Die einzelnen Eduktströme sowie auch der Produktstrom haben daher auch einen Überdruck.

Es ist daher vorteilhaft, dass die Wärmetauscher, insbesondere der (Edel-) Stahlwärmetauscher, in der Druck tragenden Hülle des Reaktors **65** angeordnet werden, da die Wärmetauscher dann nur eine geringe mechanische Festigkeit haben müssen und eine möglicherweise leicht undichte Stelle an den Wärmetauschern keinen Produktaustritt oder gar ein Sicherheitsrisiko bedeuten kann.

Vorzugsweise wird über eine weitere zentrale Düse, die am Boden der Reaktionszone angebracht wurde, der desorbierte Gasstrom als dritter Eduktstrom **63** eingedüst.

Eine entsprechende Vorrichtung mit zusätzlicher zentraler Düse ist in **Fig. 7** schematisch dargestellt.

Durch die zentrale Düse **77** wird der desorbierte Gasstrom **73** vorzugsweise ohne vorherige Erwärmung gasförmig in den Reaktor eingebracht.

Der Eduktstrom beinhaltend Siliciumtetrachlorid **72** wird entlang der Innenwand des druckbeständigen Gehäuses **75** nach Passieren eines ersten zylindrischen Umlenkelementes **79** zur Heizzone geführt, in der sich mindestens ein aktiv beheiztes Heizelement **78** befindet. Zum Beispiel kann dieses Heizelement als elektrische Widerstandsheizung ausgelegt werden, aber auch induktive Heizmethoden sind denkbar.

Die Heizelemente können sich einzeln auf dem Radius verteilt befinden, oder es kann auch aus einem mäanderförmigen Heizband bestehen, das einen gesamten Ring bildet, oder aus mehreren mäanderförmigen Heizteilringen bestehen. Eine detaillierte Beschreibung eines mäanderförmigen Heizelementes wird in Patentschrift WO 03/073794 A1 wiedergegeben.

Ein zylindrisches Umlenkelement kann ohne sich darauf zu beschränken zum Beispiel aus einem einfachen Hohlzylinder aus Graphit bestehen. Ein Umlenkelement verursacht eine Änderung der Hauptfließrichtung des Gases um 180°.

Besagter Eduktstrom wird entlang besagter Heizelemente geführt und so auf eine höhere Temperatur erhitzt. Danach passiert der Eduktstrom ein zweites zylindrisches Umlenkelement **79.** Erst nach dem Passieren eines dritten Umlenkelements **79** wird dem Siliciumtetrachlorid enthaltendem Eduktstrom über einen Düsenkreis **76** ein weiterer Eduktgasstrom **71** beinhaltend Wasserstoff hinzugefügt. Hier beginnt die Reaktionszone der Vorrichtung, in der sich die beiden Eduktströme vermischen und zu dem gewünschten Produkt reagieren.

Nach dem Passieren zweier weiterer zylindrischer Umlenkelementen **79** wird zu diesem Gasstrom ein weiterer Eduktgasstrom, nämlich der desorbierte Gasstrom **73,** beinhaltend Dichlorsilan über eine in der Reaktionszone zentral angebrachten Düse **77** hinzugefügt werden. Alle Komponenten der Eduktgasströme können hier miteinander die gewünschten Reaktionen ausführen, bevor sie als Produktstrom **74** die Reaktionszone in Richtung der ersten Wärmetauschereinheit verlassen.

Die Temperatur in der Reaktionszone **(RZ),** bei der sich das chemische Gleichgewicht der Reaktion einstellt, ergibt sich aus der Mischtemperatur der Summe der Eduktströme Siliciumtetrachlorid und Wasserstoff abzüglich der endothermen Energie, die für die Reaktion von Siliciumtetrachlorid und Wasserstoff zu Trichlorsilan und HCl benötigt wird.

Der Gasstrom aus der Desorption wird besonders bevorzugt durch die zentrale Düse **73** in den Reaktor eingebracht.

Dadurch erhöht sich die relative Selektivität auf 165 % bezogen auf die Konvertierung ohne Verwendung von DCS.

Die relative Selektivität ist durch den molaren Anteil von Trichlorsilan zu Siliciumtetrachlorid gegeben.

Voraussetzung ist, dass in der Abscheidung eine Chlorsilansättigung von 25 %, besser 30% verwendet wurde.

Mit einer Sättigung bei der Abscheidung von kleiner als 20% reduziert sich die relative Selektivität bei der Konvertierung drastisch.

## Patentansprüche

1. Verfahren zur Produktion von Polysilicium, umfassend
a) Abscheidung von polykristallinem Silicium auf Filamenten in einem Abscheidereaktor mittels eines Reaktionsgases enthaltend eine Silicium enthaltende Komponente, die Trichlorsilan umfasst, und Wasserstoff, wobei eine molare Sättigung der Silicium enthaltenden Komponente bezüglich Wasserstoff mindestens 25% beträgt;
b) Zuführen eines Abgases aus der Abscheidung in eine Vorrichtung zum Kühlen des Abgases,
i) wobei durch die Kühlung kondensierende Komponenten des Abgases enthaltend Siliciumtetrachlorid zu einer Vorrichtung geführt werden, die eine destillative Reinigung des Kondensats ermöglicht, und
ii) bei der Kühlung nicht kondensierende Komponenten zu einer Adsorptions- bzw. Desorptionseinheit geführt werden;
c) wobei ein durch Adsorption gereinigter erster Stoffstrom jener nicht kondensierenden Komponenten erhalten wird, der Wasserstoff enthält; und
d) wobei während einer Regeneration der Adsorptionseinheit mittels Desorption und Spülen mit Spülgas ein zweiter Stoffstrom jener nicht kondensierenden Komponenten erhalten wird, der Siliciumtetrachlorid enthält, und einem Konverter zur Konvertierung von Siliciumtetrachlorid in Trichlorsilan zugeführt wird.

2. Verfahren nach Anspruch 1, wobei das Abgas in b) auf eine Temperatur von kleiner oder gleich -60°C, bevorzugt auf eine Temperatur kleiner dem Taupunkt von HCl bei entsprechendem HCl-Gehalt im Abgas und entsprechenden Druck gekühlt wird.

3. Verfahren nach Anspruch 1 oder nach Anspruch 2, wobei der Konverter einen Reaktor und eine Kühlstrecke umfasst und der zweite Stoffstrom der Desorption gemäß d) zwischen Reaktor und Kühlstrecke in den Konverter eingebracht und dort mit einem Produktgasstrom der Konvertierung vermischt wird.

4. Verfahren nach einem der Ansprüche 1 bis 3, wobei der zweite Stoffstrom der Desorption gemäß d) in gasförmigem Zustand direkt in eine Reaktionszone des Konverters eingebracht wird.

5. Verfahren nach einem der Ansprüche 1 bis 4, wobei in d) der Stoffstrom der Desorption auf den Anteil von Dichlorsilan im Stoffstrom untersucht wird, wobei, falls der prozentuale Anteil von Dichlorsilan im Stoffstrom größer als der Anteil aus der Summe aus Trichlorsilan und Siliciumtetrachlorid ist, der Stoffstrom zur Vorrichtung zum Kühlen des Abgases der Abscheidung gemäß b) geleitet und mit dem Abgas der Abscheidung gemischt wird.

6. Verfahren nach einem der Ansprüche 1 bis 5, wobei die Temperatur während der Desorption mit einer Rate von kleiner als 0.9 K/min erhöht wird.

7. Verfahren nach einem der Ansprüche 1 bis 6, wobei Wasserstoff aus dem gemäß c) durch Adsorption gereinigten ersten Stoffstrom als Reaktionsgas in der Abscheidung gemäß a) verwendet wird.

8. Verfahren nach einem der Ansprüche 1 bis 7, wobei Wasserstoff aus dem gemäß c) durch Adsorption gereinigten ersten Stoffstrom als Spülgas bei der Desorption gemäß d) verwendet wird.

9. Verfahren nach einem der Ansprüche 1 bis 8, wobei die molare Sättigung der Silicium enthaltenden Komponente bezüglich Wasserstoff in Schritt a) mindestens 30% beträgt;

## Claims

1. Process for producing polysilicon, comprising
a) deposition of polycrystalline silicon on filaments in a deposition reactor by means of a reaction gas containing a silicon-containing component comprising trichlorosilane, and hydrogen, wherein a molar saturation of the silicon-containing component based on hydrogen is at least 25%;
b) feeding an offgas from the deposition into an apparatus for cooling the offgas,
i) wherein components of the offgas which condense as a result of the cooling and contain silicon tetrachloride are conducted to an apparatus which enables distillative purification of the condensate, and
ii) components which do not condense in the course of cooling are conducted to an adsorption or desorption unit;
c) to obtain a first stream of those non-condensing components which has been purified by adsorption and contains hydrogen; and
d) to obtain, during a regeneration of the adsorption unit by means of desorption and purging with purge gas, a second stream of those non-condensing components, which contains silicon tetrachloride and is supplied to a converter for conversion of silicon tetrachloride to trichlorosilane.

2. Process according to Claim 1, wherein the offgas in b) is cooled to a temperature of less than or equal to -60°C, preferably to a temperature less than the dew point of HCl at the particular HCl content in the offgas and the particular pressure.

3. Process according to Claim 1 or according to Claim 2, wherein the converter comprises a reactor and a cooling zone and the second stream from the desorption in d) is introduced into the converter between reactor and cooling zone and is mixed there with a product gas stream from the conversion.

4. Process according to any of Claims 1 to 3, wherein the second stream from the desorption in d) is introduced in the gaseous state directly into a reaction zone of the converter.

5. Process according to any of Claims 1 to 4, wherein, in d), the stream from the desorption is studied for the proportion of dichlorosilane in the stream, wherein, if the percentage of dichlorosilane in the stream is greater than the proportion of the sum of trichlorosilane and silicon tetrachloride, the stream is passed to the apparatus for cooling the offgas from the deposition in b) and mixed with the offgas from the deposition.

6. Process according to any of Claims 1 to 5, wherein the temperature during the desorption is increased at a rate of less than 0.9 K/min.

7. Process according to any of Claims 1 to 6, wherein hydrogen from the first stream purified by adsorption in c) is used as reaction gas in the deposition in a).

8. Process according to any of Claims 1 to 7, wherein hydrogen from the first stream purified by adsorption in c) is used as purge gas in the desorption in d).

9. Process according to any of Claims 1 to 8, wherein the molar saturation of the silicon-containing component based on hydrogen in step a) is at least 30%;

## Revendications

1. Procédé de production de polysilicium, comprenant :
a) le dépôt de silicium polycristallin sur des filaments dans un réacteur de dépôt au moyen d'un gaz réactionnel contenant un composant contenant du silicium, qui comprend du trichlorosilane, et de l'hydrogène, une saturation molaire du composant contenant du silicium au regard de l'hydrogène étant d'au moins 25 % ;
b) l'introduction d'un gaz d'échappement issu du dépôt dans un dispositif pour le refroidissement du gaz d'échappement,
i) dans lequel les composants condensés par le refroidissement du gaz d'échappement contenant du tétrachlorure de silicium sont introduits dans un dispositif qui permet une purification par distillation du condensat, et
ii) les composants non condensés lors du refroidissement sont introduits dans une unité d'adsorption et de désorption ;
c) dans lequel un premier courant purifié par adsorption de ces composants non condensés, qui contient de l'hydrogène, est obtenu ; et
d) dans lequel un second courant de ces composants non condensés, qui contient du tétrachlorure de silicium, est obtenu pendant une régénération de l'unité d'adsorption par désorption et rinçage avec un gaz de rinçage, et introduit dans un convertisseur pour la conversion du tétrachlorure de silicium en trichlorosilane.

2. Procédé selon la revendication 1, dans lequel le gaz d'échappement est refroidi en b) à une température inférieure ou égale à -60 °C, de préférence à une température inférieure au point de condensation d'HCl à une teneur en HCl correspondante dans le gaz d'échappement et une pression correspondante.

3. Procédé selon la revendication 1 ou selon la revendication 2, dans lequel le convertisseur comprend un réacteur et une section de refroidissement, et le second courant de la désorption selon d) est introduit dans le convertisseur entre le réacteur et la section de refroidissement, et y est mélangé avec un courant gazeux de produits de la conversion.

4. Procédé selon l'une quelconque des revendications 1 à 3, dans lequel le second courant de la désorption selon d) est introduit directement à l'état gazeux dans une zone de réaction du convertisseur.

5. Procédé selon l'une quelconque des revendications 1 à 4, dans lequel, en d), le courant de la désorption est étudié au regard de la proportion de dichlorosilane dans le courant et, si la proportion en pourcentage de dichlorosilane dans le courant est supérieure à la proportion de la somme du trichlorosilane et du tétrachlorure de silicium, le courant est conduit dans le dispositif pour le refroidissement du gaz d'échappement du dépôt selon b) et mélangé avec le gaz d'échappement du dépôt.

6. Procédé selon l'une quelconque des revendications 1 à 5, dans lequel la température pendant la désorption est augmentée à un taux inférieur à 0,9 K/min.

7. Procédé selon l'une quelconque des revendications 1 à 6, dans lequel l'hydrogène issu du premier courant purifié par adsorption selon c) est utilisé en tant que gaz réactionnel dans le dépôt selon a).

8. Procédé selon l'une quelconque des revendications 1 à 7, dans lequel l'hydrogène issu du premier courant purifié par adsorption selon c) est utilisé en tant que gaz de rinçage lors de la désorption selon d).

9. Procédé selon l'une quelconque des revendications 1 à 8, dans lequel la saturation molaire du composant contenant du silicium au regard de l'hydrogène à l'étape a) est d'au moins 30 %;
